# EUROPÄISCHE PATENTSCHRIFT

(11) **EP 0 536 227 B1**
(45) Veröffentlichungstag und Bekanntmachung des Hinweises auf die Patenterteilung: **21.09.1994**
(21) Anmeldenummer: 91911911.5
(22) Anmeldetag: 22.06.1991
(51) Int. Cl.: H01L 29/784, H01L 21/266, H01L 21/336

(54) **VERFAHREN ZUR HERSTELLUNG EINES PMOS-TRANSISTORS, SOWIE PMOS-TRANSISTOR**
PROCESS FOR MANUFACTURING PMOS-TRANSISTORS AND PMOS-TRANSISTORS THUS PRODUCED
PROCEDE DE FABRICATION DE TRANSISTORS M.O.S. POSITIFS ET TRANSISTORS M.O.S. POSITIFS AINSI PRODUITS

(30) Priorität: 23.06.1990 DE 4020076
(43) Veröffentlichungstag der Anmeldung: 14.04.1993
(73) Patentinhaber: EL-MOS ELEKTRONIK IN MOS-TECHNOLOGIE GmbH, D-44227 Dortmund (DE)
(72) Erfinder: ROTH, Walter, D-4600 Dortmund 1 (DE)
(74) Vertreter: Dallmeyer, Georg, Dipl.-Ing.
(86) Internationale Anmeldenummer: EP9101157
(87) Internationale Veröffentlichungsnummer: WO9200608

(56) Entgegenhaltungen:
- DE-A- 2 636 214
- FR-A- 2 216 676
- FR-A- 2 331 884
- PATENT ABSTRACTS OF JAPAN, vol. 12, No. 115 (E-599) 12 April 1988 ; & JP-A-62 245 675
- IBM TECHNICAL DISCLOSURE BULLETIN, volume 26, No. 6, November 1983, New York, US, pp. 2682-2683 ; D.A. BADAMI et al. : "Tapered photoresists for a doping profile".

## Beschreibung

Die Erfindung betrifft ein Verfahren zur Herstellung eines PMOS-Transistors, sowie einen PMOS-Transistor nach dem Oberbegriff des Hauptanspruchs bzw. des Anspruchs 16.

Im Bereich der Automobilelektronik und der Industrieelektronik werden vielfach Schaltungen verwendet, die mit Spannungen um 24 Volt betrieben werden. Solche Schaltungen sind mit diskreten Transistoren problemlos zu verwirklichen. Bei monolithisch integrierten Lösungen ergeben sich bei den gängigen Technologien (TTL, CMOS, NMOS) Schwierigkeiten mit der Spannungsfestigkeit der integrierten Transistoren. Dies liegt zum Teil daran, daß die Herstellprozesse für eine Betriebsspannung von ca. 5 Volt entwickelt wurden und zum Teil daran, daß kleine Bauelementgeometrien und niedrige parasitäre Widerstände gewünscht sind.

Um auch der Nachfrage nach höher-spannungsfesten Schaltungen nachkommen zu können, sind recht komplexe Produktionsverfahren wie der BICMOS-Herstellungsprozeß entwickelt worden, mit dem sowohl kleine nieder-spannungsfeste Transistoren als auch höher-spannungsfeste Transistoren bis ca. 40 bis 60 Volt Spannungsfestigkeit, z.B. Ausgangstreiber mittlerer Leistung, herstellbar sind. Für einen BICMOS-Herstellungsprozeß, der bipolare und CMOS-Komponenten liefert, werden etwa 17 Maskenebenen gebraucht, so daß die Herstellkosten für eine solche Schaltung etwa das Doppelte des Herstellprozesses für eine Standard-CMOS-Schaltung betragen.

Der von der Firma ELMOS, Dortmund, entwickelte CMOS-Herstellprozeß läßt wegen besonders günstiger Dotierungsverläufe der Drain-Dioden eine Betriebsspannung von bis zu 12 Volt zu. Die entsprechend diesem Prozeß hergestellten NMOS-Transistoren sind aber nur bedingt für Open-Drain-Ausgänge geeignet. Insbesondere wäre eine Spannungsfestigkeit bis über 30 Volt insbesondere für die Automobilelektronik von Interesse.

Ein bekanntes Verfahren zur Erhöhung der Spannungsfestigkeit von MOS-Transistoren besteht in der Erniedrigung der Drain-Dotierung. Das bekannteste Verfahren ist der sogenannte lightly-doped-drain (LDD) in seinen technologischen Varianten. Meistens handelt es sich um selbstjustierende Verfahren. Zum Beispiel wird das Gate auf beiden Seiten mit einem dielektrischen Abstandsbalken, dem sogenannten Spacer, versehen. Dann wird eine niedrige Dosis implantiert. Diese Dotierung diffundiert man so tief ein, daß die seitliche Unterdiffusion das Gate erreicht. Im nächsten Schritt wird dann die hohe drain-source-Dosis implantiert und ausgeheilt. Es entsteht unter dem Spacer eine Zone schwacher Dotierung, nämlich der gewünschten LDD.

Der Vorteil dieses Verfahrens besteht in der Selbstjustierung. Die Breite der schwach-dotierten Drain-Zone wird ausschließlich von der Tiefe der ersten Diffusion, der Breite des Spacers sowie der Tiefe der drain-source-Diffusion bestimmt. Justiertoleranzen treten nicht auf. Damit ist das Verfahren insbesondere für kleinere Transistoren mit Kanallängen im 1 »m-Bereich und Spacerlängen im 0,5 »m-Bereich geeignet. Wegen der begrenzten Breite der schwach-dotierten Zone (maximal ca. 0,8 »m) ist das Verfahren jedoch nicht geeignet, Spannungsfestigkeiten um ca. 30 Volt zu erreichen.

Aus der EP-A 0 148 342 ist ein Verfahren zum gleichzeitigen Herstellen von schnellen Kurzkanal- und spannungsfesten MOS-Transistoren in VLSI-Schaltungen bekannt, mit dem sowohl Kurzkanaltransistoren mit hoher Schaltgeschwindigkeit und einer Versorgungsspannung von 5 Volt als auch Analogtransistoren mit einer Drainspannung bis 12 Volt aber mit langsamerer Schaltgeschwindigkeit gleichzeitig mit möglichst wenigen zusätzlichen Prozeßschritten herstellbar sind. Auch diese bekannten Transistoren erreichen nicht eine über 12 Volt hinausgehende Spannungsfestigkeit.

Die bisher bekannten Verfahren sind technisch relativ aufwendig und verändern vor allen Dingen das Zeit-Temperatur-Budget eines CMOS-Herstellprozesses, so daß die Herstellung spannungsfester Halbleiterelemente nicht kompatibel mit dem Standard-CMOS-Herstellprozeß ist. Aus diesem Grund können die bekannten Verfahren auch nicht ohne weiteres in einen bestehenden Herstellprozeß integriert werden.

Aus der US-A-4 908 326 ist ein Verfahren zur Herstellung einer MOS-Struktur bekannt, bei der der "spacer" für die Ionen-Implantationen mit einer besonderen Kontur ausgebildet ist.

Das IBM Technical Disclosure Bulletin, Vol. 26, No. 6, November 1993, Seiten 2682 und 2683 beschreibt eine Halbleiterstruktur, bei der eine photoresistive Schicht an der Kante unter einem Winkel von 45° abgeschrägt ist, um dadurch die Ionen-Implantation an der Kante zu beeinflussen.

Aus der JP-A-62 245 675 ist ein LDD Typ MOS-Transistor bekannt, bei dem die Gate-Flanke zum Substrat hin einen Winkel von maximal 30° aufweist.

Die FR-A-3 316 676 beschreibt einen PMOS-Transistor, der direkt im Substrat gebildet ist und dessen Gate-Flanken nicht in Richtung des Gates geneigt sind.

Der Erfindung liegt die Aufgabe zugrunde, ein Verfahren zur Herstellung eines PMOS-Transistors zu schaffen, mit dem eine äußerst hohe Spannungsfestigkeit ohne erheblichen Mehraufwand im Herstellungsprozeß bei voller Kompatibilität mit einem Standard-CMOS-Herstellungsprozeß erzielbar ist, sowie einen PMOS-Transistor zu schaffen, der eine äußerst hohe Spannungsfestigkeit aufweist.

Zur Lösung dieser Aufgabe ist erfindungsgemäß bei einem Verfahren zur Herstellung eines PMOS-Transistors in einem p-dotierten Substrat
- durch Erzeugen einer n-dotierten Wanne durch Implantation und anschließender Diffusion,
- durch Herstellen der Source-, Drain- und Gate-Bereiche sowie des Zwischen- und Isolationsoxids nach bekannten Verfahrensschritten der MOS-Technologie, wobei die Maskierung für die Ionen-Implantationen durch photolithographische Strukturen erfolgt, und
- durch Isolieren des Transistors mit einer Feldoxidschicht, oder durch eine dielektrische Isolation (SOI-Technologie) vorgesehen,
- daß der von der photolithographischen Strukturierung nach der Gate-Ätzung verbliebene Photolack als Maskierung des Drain-Gebiets an dem gate-seitigen Ende für mindestens eine p⁻-Implantation verwendet wird, wobei ein zur Oberfläche des Drain-Bereichs abfallender Rand an der Gate-Kante in der Photolackschicht erzeugt wird, so daß die Photolackschicht eine zur Gate-Kante hin abnehmende Dicke aufweist, wobei beim Einbringen der Implantation die Flanke des Implantationskonzentrationsprofils aufgrund des abfallenden Randes zu dem unter dem Gate-Bereich befindlichen Kanal hin abgelenkt wird.

Der PMOS-Transistor in einem p-dotierten Substrat mit einer n-dotierten Wanne, in der eine Source und ein Drain verlaufen, einer Isolation aus einer Feldoxidschicht, einer zwischen der Source und dem Drain verlaufenden Gateoxidschicht mit einem darüber angeordneten Gate ist dadurch gekennzeichnet, daß die p⁺-Zone des Drains von der Gate-Kante zurückgezogen ist und daß mindestens eine schwach dotierte Implantation mit dem Gate überlappt, wobei die Flanke der maximalen Dotierungskonzentrationslinie in Richtung des Gates geneigt ist.

Die Erfindung schafft einen PMOS-Transistor, bei dem insbesondere bei Drain-Spannungen oberhalb 20 Volt das Gateoxid wirksam entlastet ist, so daß dort keine Langzeitschäden oder gar dielektrische Durchbrüche entstehen können. Der auf Grund des erfindungsgemäßen Herstellverfahrens entstehende PMOS-Transistor weist eine Spannungsfestigkeit von ca. 50 Volt auf, wobei der Herstellprozeß für einen solchen PMOS-Transistor voll kompatibel zum Standardprozeß ist. Die Kompatibilität ist darin begründet, daß an den die Diffusionsvorgänge bestimmenden Temperatur-Zeit-Kenndaten des Herstellprozesses wenn überhaupt nur vernachlässigbare Änderungen vorgenommen werden müssen. Für die prinzipiellen Dotierungsverläufe gilt beim erfindungsgemäßen PMOS-Transistor, daß weiche, niedrig-dotierte p-n-Übergänge mit möglichst großen Verrundungsradien eine gute Spannungsfestigkeit ergeben. Dieses Prinzip wird erfindungsgemäß durch einen abfallenden Rand des Photolacks verwirklicht, der eine Maskierung mit unterschiedlicher Filterwirkung bewirkt, so daß im Übergangsbereich der Beschuß mit Borionen nicht vollständig absorbiert wird, sondern ein Teil hindurchdringt und die Steilheit der Flanken der schwach-dotierten Drainzone reduziert. Auf diese Weise gelingt es, den Spannungsabfall auf eine größere Strecke zu verteilen, so daß die Spannungsfestigkeit erhöht wird. Außer der Erhöhung der Spannungsfestigkeit können auch die Dimensionen der Halbleiterstrukturen verringert werden, insbesondere die Kanallänge verkürzt werden.

Zur Erhöhung der Spannungsfestigkeit der Drain-Diode wird eine tiefe Ionenimplantation unter die p⁺-Zone des Drains geschossen. Dabei ist das Implantationsprofil teilweise durch seitliche Streuung mit dem Gate überlappt. Die p⁺-Zone des Drains wird vom Gate-Ende zurückgezogen, so daß sich die Drain-Gate-Spannung zum Teil über eine Raumladungszone in der niedrig-dotierten Drain-Zone abbauen kann. Wesentlich ist dabei, daß die Flanke des Implantationsprofils in Richtung zum Gate hin geneigt ist, und die maximale Konzentration nicht an der Oberfläche, sondern in etwa 0,5 »m Tiefe erreicht wird. Dadurch ergibt sich eine wirkungsvolle Entlastung des Gateoxids, so daß letztlich eine Erhöhung der Spannungsfestigkeit der Drain-Diode auf ca. 50 Volt erreicht wird.

Vorzugsweise ist vorgesehen, daß unmittelbar nach der ersten tiefen Ionenimplantation unter die p⁺-Zone des Drains eine zweite Implantation über die Tiefe der p-Implantation geschossen wird, deren Tiefe gegenüber der ersten Implantation reduziert ist. Die zweite Ionenimplantation mildert den Effekt des sog. Pinch-Widerstandes ab, der als Serienwiderstand zum Transistor dessen Einschaltwiderstand erhöht. Die Dosis der zweiten Implantation ist so gewählt, daß eine Transistordurchbruch-Spannung oberhalb von 40 Volt erhalten bleibt.

Eine Weiterbildung der Erfindung sieht vor, daß der nach der Gateätzung auf dem Gate verbliebene Photolack zur Stabilisierung ca. 1 Stunde bei ca. 160 °C polymerisiert wird. Danach ist der Lack restlos polymerisiert und relativ unempfindlich gegen Lösungsmittel und Entwickler.

Je dicker der Photolack aufgetragen ist, je höher können die Beschleunigungsspannungen für den Ionenbeschuß eingestellt werden und umso tiefer läßt sich die Implantation einbringen.

Für eine zuverlässige Ausmaskierung kann zusätzlich zu dem Photolack eine Siliziumoxidschicht vorgesehen sein.

Im folgenden wird unter Bezugnahme auf die Zeichnungen ein Ausführungsbeispiel der Erfindung näher erläutert.

Es zeigen
- Fig. 1: den erfindungsgemäßen PMOS-Transistor in einer perspektiven, geschnittenen Darstellung, und
- Fig. 2: einen Schnitt durch den Drain an seinem gate-seitigen Ende.

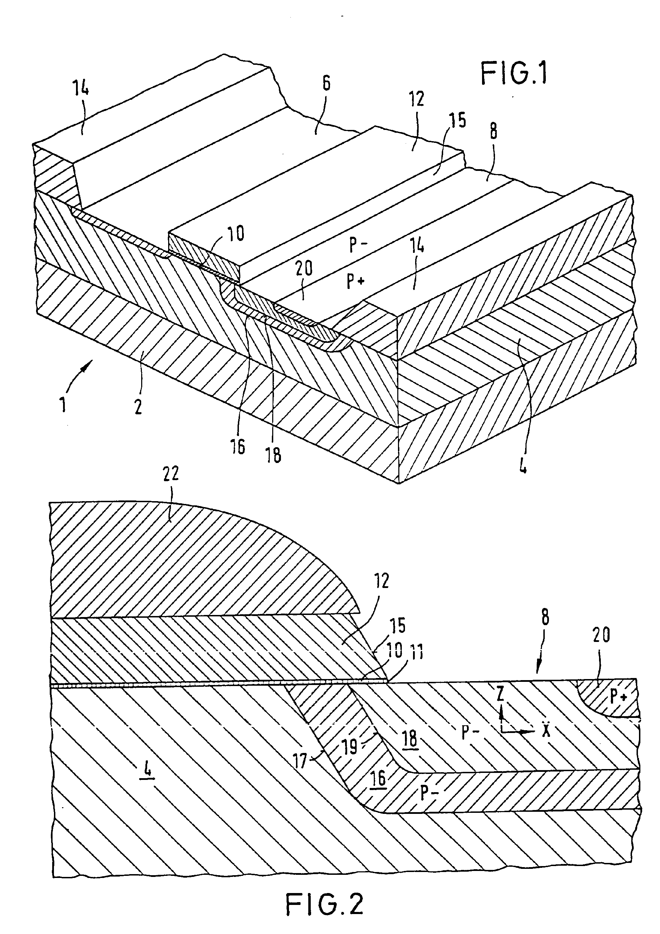

Fig. 1 zeigt einen perspektivischen Teilschnitt durch einen PMOS-Transistor 1 in einem p-dotierten Substrat 2 aus Silizium, der in eine n-dotierte Wanne 4 eingebettet ist. Die n-dotierte Wanne nimmt eine p-dotierte Source 6 sowie einen p-dotierten Drain 8 auf. Zwischen Source und Drain ist das Gateoxid 10, z.B. eine Siliziumdioxid-Schicht von 45 nm Dicke, und darüber das Gate 12 aus Polysilizium mit einer Schichtstärke von ca. 450 nm angeordnet. An dem dem Gate 12 abgewandten Ende von Source und Drain ist jeweils zur Isolierung eine Feldoxidschicht 14 mit einer Dicke von 800 nm aufgetragen. Darüber kann noch eine in der Zeichnung nicht dargestellte Passivierungsschicht angeordnet sein.

Der Drain zeigt im Schnitt gesehen eine dreifache Implantation. Die erste tiefe Implantation 16 mit Borionen erreicht eine Tiefe von ca. 0,8 »m, während die zweite Implantation 18 eine Tiefe von ca. 0,4 »m erreicht.

Die p⁺-Implantation 20 der p⁺-Draindotierung wird als letzte durchgeführt und weist sowohl zum Gate 12 als auch zur Feldoxidschicht 14 einen Abstand auf.

Fig. 2 zeigt das gate-seitige Ende des Drains 8, wobei die p⁺-Implantation 20 einen Abstand zur Gatekante aufweist.

In Fig. 2 ist oberhalb des Gates 12 eine Photolackschicht 22 eingezeichnet, die zur Gate-Kante 11 hin abgeflacht ist, d.h. eine abnehmende Dicke aufweist. Die Abflachung kann wie in Fig. 2 gezeigt bogenförmig oder aber auch stufenförmig verlaufen und mit einem Abstand von der Gate-Kante 11 beginnen, der vorzugsweise im Bereich zwischen dem 0,5 - und dem zweifachen der Schichtdicke der Photolackschicht 22 liegt. Die abnehmende Stärke der Photolackschicht führt zu einer schrägen Flanke der Linien 17,19 maximaler Dotierungskonzentration im Überlappungsbereich der seitlichen Unterdiffusionen der Doppelimplantationen mit dem Gate 12 und verhindert eine steile Flanke der Linien 17,19, weil die Beschußintensität mit Borionen im Randbereich des Gates 12 sich nicht sprunghaft ändert.

Die Gateflanke 15 kann abweichend von Fig.1 auch unter einem Winkel von z.B. 60° zur Oberfläche des Drains 8 verlaufen, um bei den Borionenimplantationen 16 und 18 im Überlappungsbereich des Drains mit dem Gate die Linie maximaler Konzentration der seitlichen Streuung zusätzlich gateseitig zu verschieben und den in Verbindung mit der Profilierung des Photolacks geschilderten Effekt zu verstärken. Die in den Fig. 1 und 2 dargestellten Begrenzungslinien 17,19 der Implantationen 16 und 18 sind Linien maximaler Konzentration.

Der PMOS-Transistor wird in einem n-Wannen-Prozeß in einer diffundierten n-Wanne hergestellt. Die Herstellung der Wanne durch Eindiffusion einer in die Silizium-Oberfläche implantierten Phosphordotierung bedingt zweierlei.
1. Die fertige Wanne hat an der Oberfläche die höchste Dotierungskonzentration.
2. Damit ohne zusätzliche Maßnahmen die Feldschwellspannung bei ca. 20 V liegt, muß die Oberflächenkonzentration ca. etwa 2 x 10¹⁶ cm⁻³ liegen. Daraus ergibt sich die für eine gewünschte Wannentiefe erforderliche Dotierungsdosis sowie die Diffusionstemperatur und -zeit.

Für die prinzipiellen Dotierungsverläufe gilt beim PMOS-Transistor, daß weiche, niedrig-dotierte p-n-Übergänge mit möglichst großen Verrundungsradien eine hohe Spannungsfestigkeit ergeben. Die Erhöhung der Spannungsfestigkeit erfordert zum CMOS-Standardherstellungsprozeß zusätzlich einen photolithographischen Prozeßschritt und die bereits beschriebene Doppelimplantation. Temperatur- und Zeitparameter der Diffusionen werden nicht geändert, womit die volle Kompatibilität zum Standardprozeß erhalten bleibt. Der Transistor ist wie folgt aufgebaut:

Die Source-Seite und die Schwellenspannungs-Einstellung sind mit dem Standard-Transistor identisch. Zur Erhöhung der Spannungsfestigkeit der Draindiode wird die tiefe Borimplantation 16 (350 keV, 1,5 x 10¹² cm⁻²) mit einer Peaktiefe von etwa 0,8 »m unter die p⁺-Zone 20 des Drains 8 geschossen. Dies bewirkt eine Erhöhung der Spannungsfestigkeit der Draindiode auf ca. 50 V. Die p⁺-Zone 20 des Drains wird vom Gate-Ende zurückgezogen, so daß sich die Drain-Gate-Spannung zum Teil über eine Raumladungszone in der niedrig-dotierten Drainzone 16, 18 abbauen kann. Dies ergibt eine wirkungsvolle Entlastung des Gateoxids 10.

Der Nachteil des so entstehenden sog. Pinch-Widerstands besteht jedoch darin, daß er als Serienwiderstand zum Transistor dessen Einschaltwiderstand erhöht. Um diesen Effekt abzumildern, wird die zweite Implantation 18 über die tiefe p⁻-Implantation 16 geschossen. Die Dosis ist so gewählt, daß eine Transistordurchbruch-Spannung oberhalb von 40 V erhalten bleibt. Die Implantationstiefe von ca. 0,4 »m sorgt dafür, daß die Konzentration des Bors direkt unter dem Gateoxid 10 niedrig bleibt, andererseits aber auch nicht das für die Spannungsfestigkeit der Diode erforderliche tiefe Implantationsprofil mit einer Peaktiefe von 0,8 »m gestört wird.

Um eine optimale Justierung der beiden Zusatzimplantationen 16, 18 bezüglich der Gate-Kante 11 zu erreichen, wird eine selbstjustierende Prozeßführung angewendet. Sie sorgt dafür, daß eine sichere Überlappung des Gates 12 über die an der Gatekante 11 endenden Implantationsprofile entsteht. Diese Prozeßführung gestattet es, das schwach dotierte auslaufende Ende der beiden Implantationsprofile unter das Gate-Ende zu positionieren, wodurch es möglich ist, die geforderte Spannungsfestigkeit zu erzielen.

Zur Herstellung von HV-PMOS-Transistoren wird der Standardprozeß wie folgt erweitert:

Nach der Polysiliziumätzung wird der Photolack 22 auf dem Polysilizium des Gates 12 belassen. Dieser Lack ist für den anschließenden selbstjustierten Implantationsprozeßschritt erforderlich. Zur Stabilisierung des Lacks werden die Waferscheiben bei 160 °C eine Stunde lang ausgeheizt. Danach ist der Lack restlos polymerisiert und relativ unempfindlich gegen Lösungsmittel und Entwickler. Es wird nun eine zusätzliche Schicht Photolack neu aufgebracht. Dieser Lack wird mit der Maske für die p⁻-Drain-Zonen belichtet und entwickelt. Die Öffnungen in der Maske überlappen die Drain-Gebiete ringsum um ca. 3 »m, damit sichergestellt ist, daß alle p⁺-Zonen nachher von einer p⁻-Zone umgeben sind. Die gate-seitige Begrenzung der Implantationszone wird durch das Polysilizium-Gate mit dem noch darauf vorhandenen Lack gebildet. In diese Öffnung werden nun direkt nacheinander die flache und die tiefe p⁻-Drain-Implantation 16,18 in beliebiger Reihenfolge geschossen. Der Lack wird danach komplett entfernt. In dem nächsten photolithographischen Prozeßschritt, der bereits wieder zum Standard CMOS-Prozeß gehört, wird die p⁺-Drain-Zone 20 definiert (Maske P). Die p⁺-Drain-Zone 20 beginnt in einem Abstand von maximal 3 »m vom Gate 12. Da die Maske justiert werden muß, ist dieser Abstand von der Genauigkeit der Justierung und von der Maßhaltigkeit der Abbildung abhängig. Deshalb muß zusätzlich zum Platzbedarf der Raumladungszone von etwa 1,5 »m ein Sicherheitszuschlag für Justierfehler vorgesehen werden.

Nach der Implantation der p⁺-Drain-Dotierung entspricht der Hochvolt-PMOS-Herstellungsprozeß wieder dem Standardprozeß. Da bei der p⁺-Implantation als Maskierung der PMOS-Kanäle nur noch das Polysilizium mit einer Schichtdicke von 450 nm vorhanden ist, muß diese Implantation mit B⁺ durchgeführt werden.

Die durch die beiden p⁻-Drain-Implantationen erzeugte p⁻-Schicht ermöglicht auch die Herstellung von hochohmigen Widerständen, z.B. 6 kΩ/□, NPN Bipolartransistoren, P-Kanal J-FETs sowie Schwellspannungserhöhungen für Metall-Feld-Transistoren oder Verbesserung der Kontaktwiderstände von Substratkontakten.

## Patentansprüche

1. Verfahren zur Herstellung eines PMOS-Transistors (1) in einem p-dotierten Substrat (2)
- durch Erzeugen einer n-dotierten Wanne (4) durch Implantation und anschließender Diffusion,
- durch Herstellen der Source-, Drain- und Gate-Bereiche sowie des Zwischen- und Isolationsoxids nach bekannten Verfahrensschritten der MOS-Technologie, wobei die Maskierung für die Ionen-Implantationen durch photolithographische Strukturen erfolgt, und
- durch Isolieren des Transistors (1) mit einer Feldoxidschicht (14), oder durch eine dielektrische Isolation (SOI-Technologie)
**dadurch gekennzeichnet**,
- daß der von der photolithographischen Strukturierung nach der Gate-Ätzung verbliebene Photolack (22) als Maskierung des Drain-Gebiets (8) an dem gate-seitigen Ende für mindestens eine p⁻-Implantation verwendet wird, wobei ein zur Oberfläche des Drain-Bereichs (8) abfallender Rand an der Gate-Kante (11) in der Photolackschicht (22) erzeugt wird, so daß die Photolackschicht (22) eine zur Gate-Kante (11) hin abnehmende Dicke aufweist, wobei beim Einbringen der Implantation die Flanke (17, 19) des Implantationskonzentrationsprofils (16, 18) aufgrund des abfallenden Randes zu dem unter dem Gate-Bereich (12) befindlichen Kanal hin abgelenkt wird.

2. Verfahren nach Anspruch 1, dadurch gekennzeichnet, daß durch die Maskierung ein p⁻-dotiertes Material, vorzugsweise Bor, mit hoher Energie auf fertige Tiefe der Dotierung implantiert wird.

3. Verfahren nach einem der Ansprüche 1 oder 2, dadurch gekennzeichnet, daß die Dosis und Energie der ersten tiefen Implantation (16) auf ca. 1,5 x 10¹² cm⁻² und ca. 350 keV eingestellt wird.

4. Verfahren nach einem der Ansprüche 1 bis 3, dadurch gekennzeichnet, daß unmittelbar nach der ersten tiefen Implantation (16) eine zweite Implantation (18) über die tiefe p⁻-Implantation (16) geschossen wird, deren Tiefe gegenüber der ersten Implantation (16) reduziert ist.

5. Verfahren nach Anspruch 4, dadurch gekennzeichnet, daß die erste Implantation (16) auf eine Peaktiefe von ca. 0,8 »m und die zweite Implantation (18) auf eine Peaktiefe von ca.0,4 »m eingestellt wird.

6. Verfahren nach einem der Ansprüche 1 bis 5, dadurch gekennzeichnet, daß eine Photolackschicht (22) mit einer Dicke zwischen 0,8 und 1,5 »m, vorzugsweise ca. 1,1 »m verwendet wird.

7. Verfahren nach einem der Ansprüche 1 bis 6, dadurch gekennzeichnet, daß zur Maskierung zusätzlich zu der Photolackschicht (22) eine Siliziumoxidschicht verwendet wird.

8. Verfahren nach einem der Ansprüche 1 bis 7, dadurch gekennzeichnet, daß die Photolackschicht (22) vor den Implantationen bei ca. 160 °C über die Dauer von ca. einer Stunde polymerisiert wird.

9. Verfahren nach einem der Ansprüche 1 bis 8, dadurch gekennzeichnet, daß die Maskierung auf einen Abstand von der Gate-Kante (11) von mindestens 0,5 »m, vorzugsweise zwischen ca. 1,5 und 3 »m eingestellt wird.

10. Verfahren nach einem der Ansprüche 1 bis 9, dadurch gekennzeichnet, daß zum Implantieren der p⁺-Dotierung des Drains (8) die Maskenöffnung kleiner als das Drain-Gebiet eingestellt wird.

11. Verfahren nach Anspruch 10, dadurch gekennzeichnet, daß zur Feldoxidbegrenzung des Drain-Gebietes hin die Öffnung der p⁺-Maske größer ist als das Drain-Gebiet.

12. Verfahren nach einem der Ansprüche 1 bis 10, dadurch gekennzeichnet, daß die Maskierung um einen Abstand von der feldoxidseitigen Begrenzung des Drain-Gebietes von ca. 1,5 bis 3 »m kleiner eingestellt wird.

13. Verfahren nach Anspruch 1 bis 12, dadurch gekennzeichnet, daß am drainseitigen Ende des Gate-Kanals eine schräge Flanke (15) erzeugt wird, die einen Winkel von ca. 30° bis 75°, vorzugsweise 60°, mit der Oberfläche des Drains einschließt.

14. Verfahren nach Anspruch 13, dadurch gekennzeichnet, daß eine Überlappung der Photolackkante mit dem oberen Ende der Gate-Flanke (15) erzeugt wird.

15. Verfahren nach Anspruch 1 bis 14, dadurch gekennzeichnet, daß der Transistor (1) an den Seiten und nach unten durch eine dielektrische Isolationsschicht isoliert wird (SOI-Technologie).

16. PMOS-Transistor (1) in einem p-dotierten Substrat (2), mit einer n-dotierten Wanne (4), in der eine Source (6) und ein Drain (8) verlaufen, einer Isolation aus einer Feldoxidschicht (14), einer zwischen der Source (6) und dem Drain (8) verlaufenden Gateoxidschicht (10) mit einem darüber angeordneten Gate (12),
**dadurch gekennzeichet,**
daß die p⁺-Zone (20) des Drains (8) von der Gate-Kante (11) zurückgezogen ist, daß der Drain (8) eine schwachdotierte, mit dem Gate (12) überlappende Doppelimplantation (16,18) aufweist, wobei die erste tiefe Implantation eine Tiefe von 0,5 bis 1,1 »m, vorzugsweise ca. 0,8 »m, die zweite Implantation (18) die halbe Tiefe der ersten Implantation (16) aufweist, und die Flanke (15) der maximalen Dotierungskonzentrationslinie (17, 19) in Richtung des Gates (12) geneigt ist.

17. PMOS-Transistor nach Anspruch 16, dadurch gekennzeichnet, daß die drainseitige Flanke (15) des Gates (12) mit der Oberfläche des Drains (8) einen Winkel von ca. 30° bis 75°, vorzugsweise 60°, einschließt.

18. PMOS-Transistor nach einem der Ansprüche 16 oder 17, dadurch gekennzeichnet, daß der Abstand der p⁺-Zone (20) im Drain (8) von dem Gate (12) mindestens 0,5 »m, vorzugsweise 1,5 bis 3,0 »m beträgt.

## Claims

1. A method for producing a PMOS transistor (1) in a p doped substrate (2),
- by producing a n doped trough (4) by implantation and subsequent diffusion,
- by producing the source, drain and gate regions, as well as the intermediate and insulating oxide according to method steps know in MOS technology, the masking for the ion implantations being provided by photolithographic patterns, and
- by insulating the transistor (1) by means of a field oxide layer (14) or by a dielectric insulation (SOI technology),
characterised in
- that the photoresist (22) left of the photolithographic pattern after the etching of the gate is used as the masking of the drain region (8) at the gate-side end for at least one p⁻ implantation, an edge that falls towards the surface of the drain region (8) being provided in the photoresist layer (22) at the gate edge (11) such that the photoresist layer (22) has a thickness decreasing towards the gate edge (11), the flank (17, 19) of the implantation concentration profile (16, 18) being deflected towards the channel below the gate region (12) because of the falling edge when the implant is introduced.

2. The method of claim 1, characterised in that a p⁻ doped material, preferably boron, is implanted with high energy to the final depth of the doping through the masking.

3. The method of one of claims 1 or 2, characterised in that the dose and the energy of the first deep implantation (16) is set to about 1.5 x 10¹² cm⁻² and about 350 keV.

4. The method of one of claims 1 to 3, characterised in that immediately after the first deep implantation (16), a second implantation (18) is driven in above said deep p⁻ implantation (16), the depth thereof being reduced compared to that of the first implantation (16).

5. The method of claim 4, characterised in that said first implantation (16) is set to a peak depth of about 0.8 »m and said second implantation (18) is set to a peak depth of about 0.4 »m.

6. The method of one of claims 1 to 5, characterised in that a photoresist layer (22) with a thickness between 0.8 and 1.5 »m, preferably about 1.1 »m, is used.

7. The method of one of claims 1 to 6, characterised in that, for masking, a silicon oxide layer is used in addition to the photoresist layer (22).

8. The method of one of claims 1 to 7, characterised in that the photoresist layer (22) is polymerized for about 1 hour at about 160°C prior to the implantations.

9. The method of one of claims 1 to 8, characterised in that the masking is set to a distance from the gate edge (11) of at least 0.5 »m, preferably between about 1.5 »m and about 3 »m.

10. The method of one of claims 1 to 9, characterised in that for implanting the p⁺ doping of the drain (8), the mask opening is set smaller than the drain region.

11. The method of claim 10, characterised in that for defining the field oxide of the drain region, the opening of the p⁺ mask is larger than the drain region.

12. The method of one of claims 1 to 10, characterised in that the masking is set smaller by a distance from the field oxide side border of the drain region that is about 1.5 to 3 »m.

13. The method of one of claims 1 to 12, characterised in that at the drain-side end of the gate channel an inclined flank (15) is produced that encloses an angle of about 30° to 75°, preferably 60°, with the surface of the drain.

14. The method of claim 13, characterised in that an overlapping of the photoresist edge with the upper end of the gate flank (15) is produced.

15. The method of one of claims 1 to 14, characterised in that the transistor (1) is insulated at the sides and in the downward direction by a dielectric insulating layer (SOI technology).

16. A PMOS transistor (1) in a p doped substrate (2) with a n doped trough (4) in which a source (6) and a drain (8) extend, an insulation consisting of a field oxide layer (14), and a gate oxide layer (10) extending between the source (6) and the drain (8) and having a superimposed gate (12),
characterized in
that the p⁺ region (20) of the drain (8) is withdrawn from the gate edge (11), that the drain (8) has a weakly doped double implantation (16, 18) overlapping with said gate (12), the first deep implantation (16) having a depth from 0.5 to 1.1 »m, preferably about 0.8 »m, and the second implantation (18) having half the depth of said first implantation (16) and that the flank (15) of the maximum doping concentration line (17, 19) is inclined towards the gate (12).

17. The PMOS transistor of claim 16, characterised in that the drain-side flank (15) of the gate (12) encloses an angle of about 30° to 75°, preferably 60°, with the surface of the drain (8).

18. The PMOS transistor of one of claims 16 or 17, characterised in that the distance of the p⁺ region (20) of the drain (8) from the gate (12) is at least 0.5 »m, preferably between about 1.5 »m and about 3.0 »m.

## Revendications

1. Procédé de fabrication d'un transistor (1) MOS à canal P dans un substrat (2) dopé du type p
- en produisant une cuvette (4) dopée du type n par implantation et diffusion à la suite,
- en fabriquant les zones de source, de drain, et de grille, ainsi que de l'oxyde intermédiaire et de l'oxyde d'isolation selon les pas connus du procédé de la technologie MOS, le masquage pour les implantations d'ions étant fait par structures photolithographiques, et
- en isolant le transistor (1) avec une couche d'oxyde de champ (14) ou par un isolant diélectrique (technologie SOI),
caractérisé
- par le fait que l'on emploie le vernis photosensible (22), subsistant de la structuration photolithographique après attaque chimique pour former la grille comme masquage de la zone de drain (8) à l'extrémité située du côté de la grille pour au moins une implantation p⁻, étant précisé qu'à la bordure (11) de la grille, on produit dans la couche de vernis photosensible (22) un bord de pente descendante en direction de la surface de la zone de drain (8), de sorte que la couche de vernis photosensible (22) présente une épaisseur qui va en diminuant en direction de la bordure (11) de la grille, étant précisé que lors de la mise en oeuvre de l'implantation, du fait du bord en pente descendante, la bordure (17, 19) du profil de la concentration d'implantation (16, 18) est déviée en direction du canal situé sous la zone de grille (12).

2. Procédé selon la revendication 1, caractérisé par le fait que grâce au masquage on implante un matériau dopé de type p⁻, de préférence du bore, de haute énergie, sur une profondeur finie du dopage.

3. Procédé selon l'une des revendications 1 ou 2, caractérisé par le fait que l'on régle la dose et l'énergie de la première implantation profonde (16) sur environ 1,5 x 10¹² cm⁻² et environ 350 keV.

4. Procédé selon l'une des revendications 1 à 3, caractérisé par le fait qu'immédiatement après la première implantation profonde (16), on procède rapidement, au-dessus de l'implantation profonde p⁻ (16) à une seconde implantation dont la profondeur est réduite par rapport à la première implantation (16).

5. Procédé selon la revendication 4, caractérisé par le fait que l'on règle la première implantation (16) sur une profondeur maximale d'environ 0,8 »m et la seconde implantation (18) sur une profondeur maximale d'environ 0,4 »m.

6. Procédé selon l'une des revendications 1 à 5, caractérisé par le fait que l'on emploie une couche de vernis photosensible (22) d'une épaisseur valant entre 0,8 et 1,5 »m, de préférence environ 1,1 »m.

7. Procédé selon l'une des revendications 1 à 6, caractérisé par le fait que pour le masquage, en plus de la couche de vernis photosensible (22), on emploie une couche d'oxyde de silicium.

8. Procédé selon l'une des revendications 1 à 7, caractérisé par le fait qu'avant les implantations en fait polymériser la couche de vernis photosensible (22) aux environs de 160°C pendant une durée d'environ une heure.

9. Procédé selon l'une des revendications 1 à 8, caractérisé par le fait que l'on règle le masquage à une distance du bord (11) de la grille d'au moins 0,5 »m, de préférence entre environ 1,5 et 3 »m.

10. Procédé selon l'une des revendications 1 à 9, caractérisé par le fait que pour implanter le dopage p⁺ du drain (8) on donne à l'ouverture du masque une valeur inférieure à celle du domaine du drain.

11. Procédé selon la revendication 10, caractérisé par le fait qu'en direction de la délimitation de l'oxyde de champ du domaine de drain l'ouverture du masque p⁺ est supérieure à celle du domaine de drain.

12. Procédé selon l'une des revendications 1 à 10, caractérisé par le fait que l'on réalise le masquage plus petit, pour venir à une distance de la délimitation, côté oxyde de champ, du domaine de drain d'environ 1,5 à 3 »m.

13. Procédé selon les revendications 1 à 12, caractérisé par le fait qu'à l'extrémité du canal de grille située du côté du drain est produite une bordure oblique (15) qui fait un angle d'environ 30° à 75°, de préférence 60°, avec la surface du drain.

14. Procédé selon la revendication 13, caractérisé par le fait qu'est produit un recouvrement du bord du vernis photosensible par l'extrémité supérieure de la bordure (15) de la grille.

15. Procédé selon les revendications 1 à 14, caractérisé par le fait que, sur les côtés et vers le bas, on isole le transistor (1) au moyen d'une couche isolante diélectrique (technologie SOI).

16. Transistor (1) MOS à canal P dans un substrat (2) dopé du type p, comportant une cuvette (4) dopée du type n, dans laquelle se trouvent une source (6) et un drain (8), comportant aussi une isolation constituée d'une couche d'oxyde de champ (14), une couche d'oxyde de grille (10), disposée entre la source (6) et le drain (8), avec une grille (12) disposée par-dessus,
caractérisé
par le fait que la zone p⁺ (20) du drain (8) se trouve à distance de la bordure (11) de la grille, que le drain (8) présente une double implantation (16, 18) faiblement dopée, à recouvrement avec la grille (12), la première implantation profonde présentant une profondeur de 0,5 à 1,1 »m, de préférence environ 0,8 »m, la seconde implantation (18) présentant la demi-profondeur de la première implantation (16) et la bordure (15) de la ligne (17, 19) de concentration maximale du dopage étant inclinée en direction de la grille (12).

17. Transistor MOS à canal P selon la revendication 16, caractérisé par le fait que la bordure (15), située du côté drain, de la grille (12) fait avec la surface du drain (8) un angle d'environ 30° à 75°, de préférence 6O°.

18. Transistor MOS à canal P selon l'une des revendications 16 ou 17, caractérisé par le fait que la distance entre la zone p⁺ (20) du drain (8) et la grille (12) vaut au moins 0,5 »m, de préférence 1,5 à 3,0 »m.
